# EUROPEAN PATENT APPLICATION

(11) **EP 4 686 326 A1**
(43) Date of publication of application: **28.01.2026**
(21) Application number: 25191817.3
(22) Date of filing: 25.07.2025
(51) Int. Cl.: H05K 7/14

(54) **RETAINER FOR ELECTRONIC MODULES**

(30) Priority: 25.07.2024 US 202463675424 P
(71) Applicant: Schroff GmbH, 75334 Straubenhardt (DE)
(72) Inventor: Gutierrez, Emerson, San Diego, 92104 (US); Rosano, Rossano, San Diego, 92154 (US)
(74) Representative: Barker Brettell LLP

(57) **Abstract**

A retainer (100) for securing an electronic module to a body can be provided. The retainer (100) can include a rail (104) that defines an extension axis (128) extending through a center of the rail (104), and a plurality of wedges arranged along the rail (104). The plurality of wedges can be engaged with the rail (104) to be adjustable axially and radially relative to the extension axis (128), to move between a first configuration and a second configuration. Each of a first wedge (116) and a second wedge (108) of the plurality of wedges can integrally include a wedge body (158), a first interlocking feature (188), and a second interlocking feature (188). An adjustment device (236) can adjust the plurality of wedges between the first and second configurations by compressing or expanding the wedges, causing the wedges to move radially and engage with adjacent wedges via the interlocking features (188).

## Description

### BACKGROUND

In different settings, it may be useful to secure electronic modules to other bodies. For example, it may be useful to secure a circuit card with respect to a cold plate, such that the card maintains a relatively fixed location when subjected to vibrations or other forces. Securing a circuit card to a cold plate may also support heat removal from the card, including via heat transfer from the card to the plate.

### SUMMARY

Some examples of the invention provide a retainer for securing an electronic module to a body. The retainer can include a rail that defines an extension axis extending through a center of the rail. A plurality of wedges can be arranged along the rail. The plurality of wedges can be engaged with the rail to be adjustable axially and radially relative to the extension axis, to move between a first configuration and a second configuration. Each of a first wedge and a second wedge of the plurality of wedges can integrally include a wedge body that defines a center axis substantially parallel to the extension axis. The first and second wedge can each include a first interlocking feature extending from a first body end of the wedge body, and a second interlocking feature extending from the first body end and offset from the first interlocking feature along the center axis. An adjustment device can be included that adjusts the plurality of wedges from the first configuration to the second configuration by compressing the plurality of wedges in a compression direction to urge a first ramped end portion of the first wedge against a second ramped end portion of the second wedge so that the first wedge moves radially away from the rail in an expansion direction. The adjustment device can adjust the plurality of wedges from the second configuration to the first configuration by expanding the plurality of wedges along an extension direction, opposite the compression direction, so that the first and second interlocking features of the first wedge engage, respectively, the second and first interlocking features of the second wedge, to urge the first wedge one or more of: in the extension direction, or opposite the expansion direction.

In some examples, for each of the first and second wedges, a distal end of the first interlocking feature that is disposed axially opposite the wedge body can be offset along the center axis from a distal end of the second interlocking feature that is disposed axially opposite the wedge body along the center axis.

In some examples, the first ramped end portion of the first wedge can include the first and second interlocking features of the first wedge, and the second ramped end portion of the second wedge can include the first and second interlocking features of the second wedge.

In some examples, each of the first ramped end portion and the second ramped end portion can include, for the corresponding first or second wedge, a distal ramp at a distal end of the first interlocking feature and a body ramp extending along the wedge body. The first ramped end portion being urged into the second ramped end portion can include the distal ramp of each of the first and second wedges being urged against the body ramp of the other of the first and second wedges.

In some examples, for each of the first and second ramped end portions, the distal ramp and the body ramp can be axially aligned along the center axis.

In some examples, the first interlocking feature and the second interlocking feature can be asymmetrical relative to one another about a center plane extending radially from the center axis along the expansion direction.

In some examples, the first interlocking feature can include a first hook. The first hook can include a first shank that extends from the first end of the wedge body to a first projection. The first projection can extend from the first shank toward the center axis. The first projection can include a distal ramp that can be disposed axially opposite the wedge body along the center axis and that can form part of the first ramped end portion. The distal ramp can be angled at a first angle relative to the center axis. The first projection can include an inner engagement surface, disposed between the distal ramp and the wedge body. The inner engagement surface can be angled at a second angle relative to the center axis. The first angle can be different from the second angle.

In some examples, the wedge body can include a first body ramp disposed at the first body end. The first body ramp can be angled at a third angle relative to the center axis, and the third angle can be different from the second angle.

In some examples, the first interlocking feature can include a first hook. The first hook can include a first shank that extends from the first end of the wedge body to a first projection. The first projection can extend from the first shank toward the center axis. The first projection can include an engagement surface. The engagement surface can be oriented substantially perpendicular to the center axis.

In some examples, a first end wedge of the plurality of wedges, arranged at a first end of the rail, may not include the interlocking features. Furthermore, in some examples, each of the plurality of wedges other than the first end wedge can include the interlocking features.

In some examples, the first interlocking feature can include a first hook, the first hook including a first shank that extends from the first end of the wedge body to a first projection. The first projection can extend from the first shank toward the center axis. The first projection can include an inner engagement surface, disposed between a distal end of the first interlocking feature, opposite the wedge body, and the wedge body. Adjusting the wedges from the second configuration to the first configuration by expanding the plurality of wedges along the extension direction can include moving the inner engagement surface of the first interlocking feature of the first wedge to engage with the inner engagement surface of the first interlocking feature of the second wedge.

Some examples of the invention provide a retainer for securing an electronic module to a body. The retainer can include a rail that defines an extension axis extending through a center of the rail. A plurality of wedges can be arranged along the rail. The plurality of wedges can be engaged with the rail to be adjustable axially and radially relative to the extension axis, to move between a first configuration and a second configuration. Each of a first wedge and a second wedge of the plurality of wedges can include a wedge body that defines a center axis substantially parallel to the extension axis. The first and second wedge can each include a first interlocking feature extending from a first body end of the wedge body. The first interlocking feature can include a distal ramp disposed axially opposite the wedge body along the center axis. The distal ramp can be angled at a first angle relative to the wedge axis. The first interlocking feature can include an inner engagement surface, disposed between the distal ramp and the wedge body. The inner engagement surface can be angled at a second angle relative to the wedge axis, the second angle being different from the first angle. An adjustment device can be included that adjusts the plurality of wedges from the first configuration to the second configuration by compressing the plurality of wedges in a compression direction along the extension axis to urge the distal ramp of the first wedge against the distal ramp of the second wedge so that the first wedge moves radially away from the extension axis in an expansion direction. The adjustment device can adjust the plurality of wedges from the second configuration to the first configuration by expanding the plurality of wedges along an extension direction, opposite the compression direction, so that the inner engagement surface of the first wedge engages the inner engagement surface of the second wedge to move the first wedge one or more of: in the extension direction, or opposite the expansion direction.

Some examples of the invention provide a retainer for securing an electronic module to a body. The retainer can include a rail that defines an extension axis extending through a center of the rail. A plurality of wedges can be engaged with the rail and adjustable on the rail in a compression direction, axially along the extension axis, and in an expansion direction, radially relative to the extension axis, to move from a relaxed configuration to an expanded configuration. A first wedge of the plurality of wedges can include a wedge body that defines a center axis. The first wedge can include a first interlocking feature extending from a first body end of the wedge body. The first interlocking feature can include a first hook having a first distal end opposite the wedge body along the center axis. The first wedge can include a second interlocking feature extending from the first body end of the wedge body. The second interlocking feature can include a second hook having a second distal end opposite the wedge body along the center axis. The first distal end can be axially offset from the second distal end relative to the center axis. The first wedge can be arranged on the rail so that, as the adjacent wedge is moved in an extension direction opposite the compression direction to move the plurality of wedges from the expanded configuration to the relaxed configuration, the first and second interlocking features of the first wedge can engage with interlocking features of an adjacent wedge of the plurality of wedges to urge the first wedge one or more of in the extension direction or opposite the expansion direction.

Some examples of the invention provide a method for securing an electronic module to a body. The method can include providing a rail that defines an extension axis extending through a center of the rail. The method can include arranging a plurality of wedges along the rail. The plurality of wedges can be engaged with the rail to be adjustable axially and radially relative to the extension axis, to move between a first configuration and a second configuration. Each of a first wedge and a second wedge of the plurality of wedges can integrally include a wedge body that defines a center axis substantially parallel to the extension axis. The first wedge and second wedge can include a first interlocking feature extending from a first body end of the wedge body, and a second interlocking feature extending from the first body end. The second interlocking feature can be offset from the first interlocking feature along the center axis. The method can include adjusting the plurality of wedges from the first configuration to the second configuration using an adjustment device by compressing the plurality of wedges in a compression direction to urge a first ramped end portion of the first wedge against a second ramped end portion of the second wedge so that the first wedge moves radially away from the rail in an expansion direction. The method can include adjusting the plurality of wedges from the second configuration to the first configuration using the adjustment device by expanding the plurality of wedges along an extension direction, opposite the compression direction, so that the first and second interlocking features of the first wedge engage, respectively, the second and first interlocking features of the second wedge, to urge the first wedge one or more of: in the extension direction, or opposite the expansion direction.

In some examples, for each of the first and second wedges, a distal end of the first interlocking feature that can be disposed axially opposite the wedge body can be offset along the center axis from a distal end of the second interlocking feature that can be disposed axially opposite the wedge body along the center axis.

In some examples, the first interlocking feature and the second interlocking feature can be asymmetrical relative to one another about a center plane extending radially from the center axis along the expansion direction.

In some examples, each of the first ramped end portion and the second ramped end portion can include, for the corresponding first or second wedge: a distal ramp at a distal end of the first interlocking feature, a body ramp extending along the wedge body, and an inner engagement surface disposed between the distal ramp and the body ramp. Adjusting the wedges from the first configuration to the second configuration can include the distal ramp of each of the first and second wedges being urged against the body ramp of the other of the first and second wedges.

In some examples, adjusting the wedges from the second configuration to the first configuration by expanding the plurality of wedges along the extension direction can include moving the inner engagement surface of the first interlocking feature of the first wedge to engage with the inner engagement surface of the first interlocking feature of the second wedge.

In some examples, the first interlocking feature can include a first hook. The first hook can include a shank that extends from the first end of the wedge body to a projection. The projection can extend from the shank toward the center axis. The projection can include a distal ramp that can be disposed axially opposite the wedge body along the center axis. The first projection can include an inner engagement surface, disposed between the distal ramp and the wedge body. The inner engagement surface and the distal ramp can be non-parallel.

In some examples, the wedge body can include a first body ramp disposed at the first end of the wedge body. The first body ramp can non-parallel relative to the inner engagement surface.

In some examples, the first interlocking feature can include a first hook. The first hook can include a first shank that extends from the first end of the wedge body to a first projection, the first projection extending from the first shank toward the center axis. The first projection can include an engagement surface. The engagement surface can be oriented substantially perpendicular to the center axis.

Aspects and embodiments of the invention are defined in the claims. Feature(s) of the aspects/embodiments of the invention or features otherwise disclosed herein may be used separately, together and/or be interchangeable wherever possible. Where features are, for brevity, described in the context of a single embodiment, those features may also be provided separately or in any suitable sub-combination. Features described in connection with the retainer or any feature(s) or component(s) described may have corresponding features definable and/or combinable with respect to a method or vice versa, and these embodiments are specifically envisaged.

### BRIEF DESCRIPTION OF THE DRAWINGS

The accompanying drawings, which are incorporated in and form a part of this specification, illustrate examples of the invention and, together with the description, serve to explain the principles of examples of the invention:
FIG. 1 is an axonometric view of a securement system for securing a circuit card to a cold plate;
FIG. 2 is an axonometric view of a retainer for the securement system of FIG. 1 in a first configuration, according to an example of the invention;
FIG. 3 is an exploded view of the retainer of FIG. 2;
FIG. 4 is an elevation view of a first side of the retainer of FIG. 2;
FIG. 5 is an elevation view of a second side of the retainer of FIG. 2;
FIG. 6 is a cross-sectional view of the retainer of FIG. 2, taken at VI-VI;
FIG. 7 is an axonometric view of a wedge of the retainer of FIG. 2;
FIG. 8 is an elevation view of a first side of the wedge of FIG. 6;
FIG. 9 is an elevation view of a front side of the wedge of FIG. 6;
FIG. 10 is an axonometric view of the retainer of FIG. 2 in a second configuration;
FIG. 11 is an elevation view of the retainer of FIG. 2 in the first configuration;
FIG. 12 is an elevation view of the retainer of FIG. 2 in the second configuration;
FIG. 13 is an elevation view of the retainer of FIG. 2 in a third configuration;
FIG. 14 is an elevation view of the retainer of FIG. 2 in a fourth configuration;
FIG. 15 is an elevation view of the retainer of FIG. 2 in a fifth configuration;
FIG. 16 is an elevation view of a retainer for the system of FIG. 1 in a sixth configuration, according to an example of the invention;
FIG. 17 is an elevation view of the retainer of FIG. 16 in a seventh configuration;
FIG. 18 is an elevation view of a retainer for the system of FIG. 1 in an eighth configuration, according to an example of the invention;
FIG. 19 is an elevation view of the retainer of FIG. 18 in a ninth configuration;
FIG. 20 is an axonometric view of a retainer for the securement system of FIG. 1 in a tenth configuration, according to an example of the invention;
FIG. 21 is an elevation view of the retainer of FIG. 21 in the tenth configuration,
FIG. 22 is an elevation view of the retainer of FIG. 21 in an eleventh configuration;

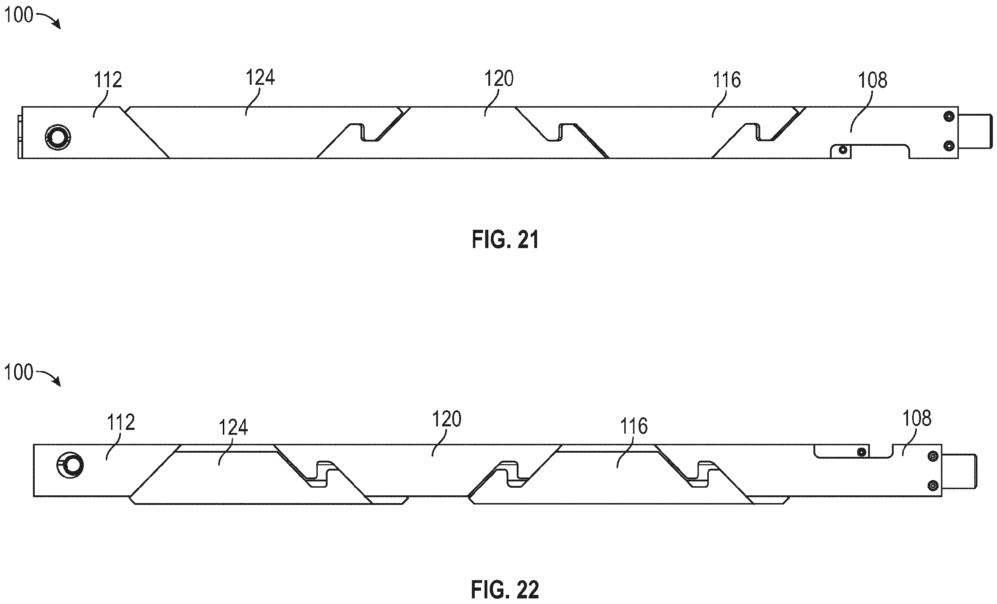

FIG. 22 is an elevation view of the retainer of FIG. 21 in a twelfth configuration;

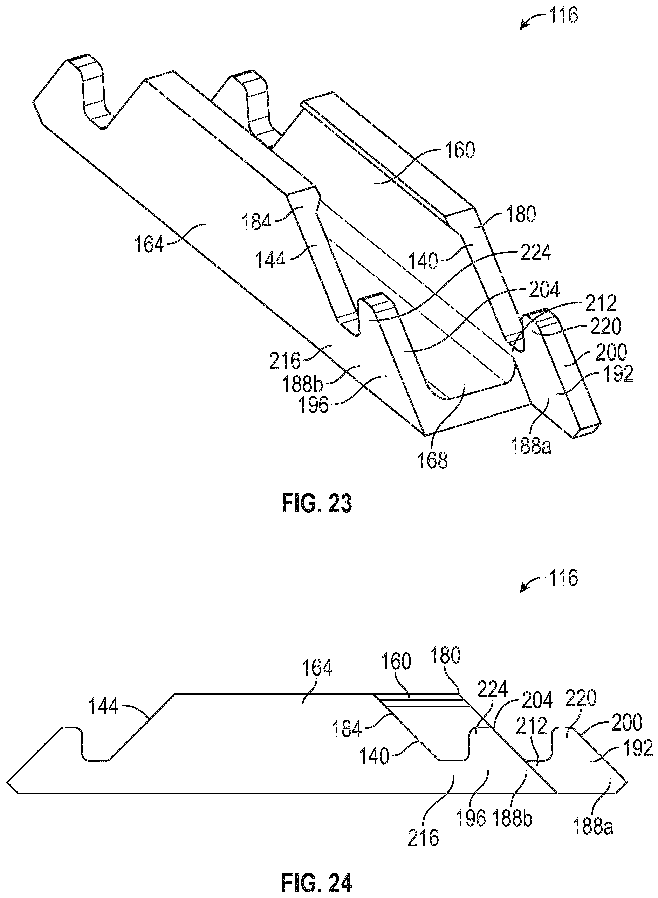

FIG. 23 is an axonometric view of a wedge of the retainer of FIG. 21; and
FIG. 24 is an elevation view of the wedge of the retainer of FIG. 21.

### DETAILED DESCRIPTION

The following discussion is presented to enable a person skilled in the art to make and use examples of the invention. Various modifications to the illustrated examples will be readily apparent to those skilled in the art, and the generic principles herein can be applied to other examples and applications without departing from examples of the invention. Thus, examples of the invention are not intended to be limited to examples shown, but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the invention. Skilled artisans will recognize the examples provided herein have many useful alternatives and fall within the scope of examples of the invention.

Conventional retainers for securing an electronic module to a body, such as a cold plate, can include sets of interleaved wedges having overlapping ramped ends. The wedges can be movably retained on a rail, which in turn can be fixed in place on the electronic module. A screw extending through the wedges can be tightened in order to compress the wedges along the rail, thereby increasing the amount of overlap of the ramped ends of the wedges and shortening the overall length of the retainer. Due to contact between the ramped ends of adjacent wedges, this collective shortening of the retainer, and the corresponding increased overlap of the wedges, can result in some of the wedges moving laterally outward (i.e., perpendicularly to the collective length of the retainer) away from the rail. With sufficient tightening of the screw, these laterally moved wedges can be moved to an installation configuration and strongly urged against the retention body to secure the electronic module to the relevant body.

In order to remove the retainer, and therefore the electronic module, from the relevant body, the screw can be loosened. Accordingly, the laterally moved (i.e., expanded) wedges can return to a relaxed configuration thereby decreasing the amount of overlap of the ramped ends of the wedges. However, in some situations, conventional designs of retainers with interleaved wedges can become stuck in the installation configuration. Specifically, frictional forces between the interleaved wedges may not allow the retainer to return to the relaxed or uninstalled configuration. Consequently, such designs may cause electronic modules to become stuck or unremovable from relevant bodies.

Examples of the disclosed invention may address these and other issues, including by providing electronic modules that can be easily installed and uninstalled and can protect against electronic modules becoming stuck to a relevant body. In some examples, the retainer described herein can mitigate the potential of becoming stuck in the installed configuration, by utilizing interlocking features disposed on the wedges. Specifically, the interlocking features of adjacent wedges can engage one another and provide a positive retraction pulling force between adjacent wedges when the retainer is moved from an installed configuration toward a relaxed configuration. For example, as the retainer is moved from the installed configuration to the relaxed configuration, the pulling force provided by the engagement of the interlocking hook features can overcome frictional forces acting between the wedges of the retainer to ensure the wedges do not remain stuck in the installed configuration.

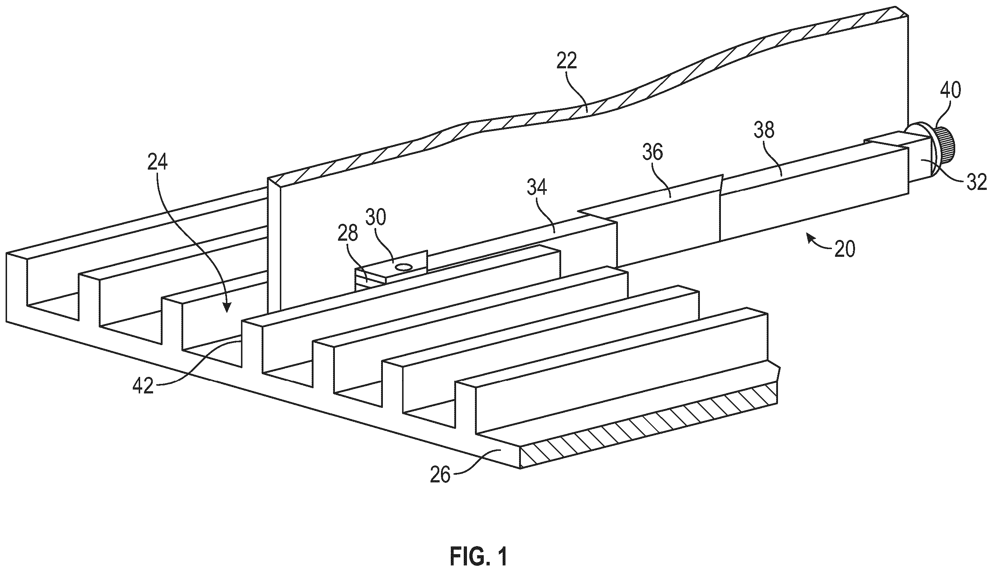

FIG. 1 depicts a retainer 20 for securing a circuit card 22 within a slot 24 on a cold plate 26 or other body. An extended rail 28 is secured to the card 22, and a set of five wedges, including end wedges 30 and 32 and inner wedges 34, 36, and 38, are arranged along the rail 28. Each of the wedges 30, 32, 34, 36, and 38, includes at least one ramped end portion with an internal end angle of 45 degrees, and the end portions of adjacent pairs of the wedges 30, 32, 34, 36, and 38 are generally seated against each other when the wedges 30, 32, 34, 36, and 38 are arranged along the rail. Once the wedges 30, 32, 34, 36, and 38 are in place on the rail 28, an adjustment device can be operated to adjust the collective of the wedges 30, 32, 34, 36, and 38. In the example of FIG. 1, for example, a screw 40 extending from the outer end of the wedge 32 can be tightened in order to collectively compress the wedges 30, 32, 34, 36, and 38 along the rail 28. As the wedges 30, 32, 34, 36 and 38 are compressed together, the contact between ramped ends of adjacent wedges causes the inner wedges 34 and 38 to move laterally away from the rail 28 and into contact with a side wall 42 of the slot 24. With appropriate tightening of the screw 40, and the corresponding collective compression of the wedges 30, 32, 34, 36 and 38, the wedges 34 and 38 can contact the wall 42 with sufficient force to secure the card 22 within the slot 24. In other examples, other adjustment devices can be used, including other screw mechanisms variously known, lever or cam mechanisms, or various types of linear or rotary actuators.

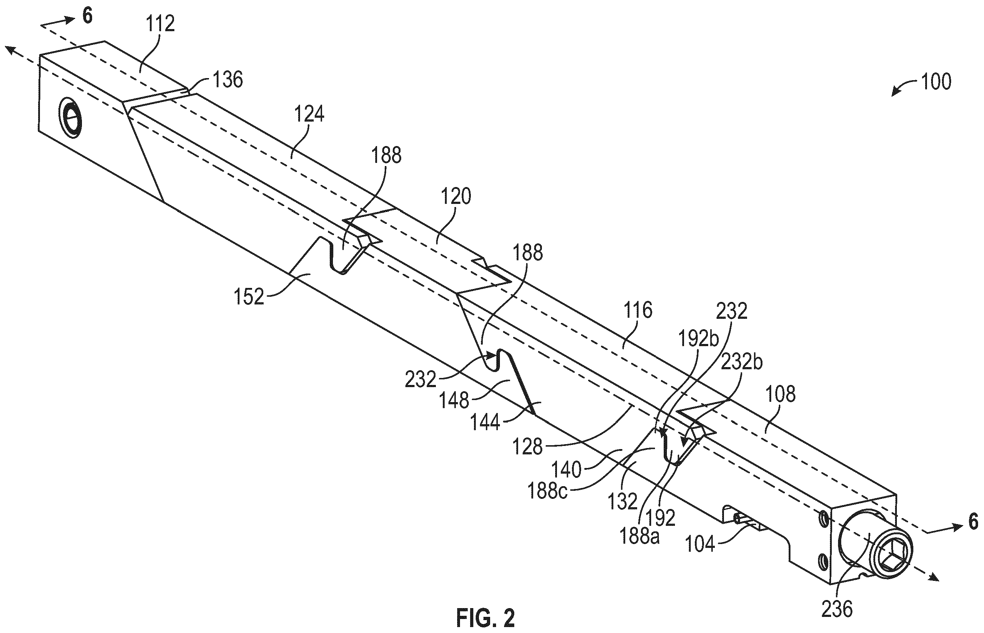

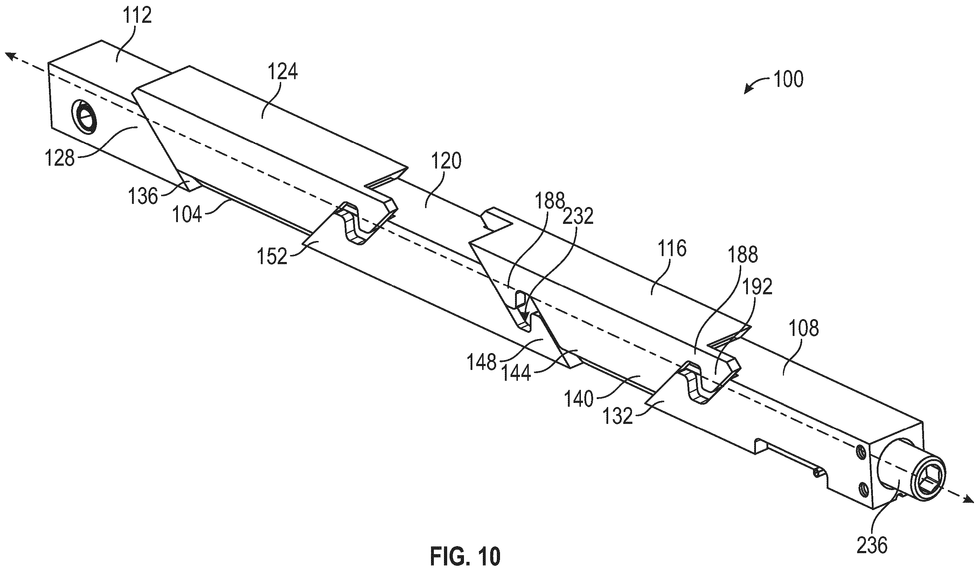

FIG. 2 depicts a retainer 100 according to one example of this disclosure. A rail 104 can be secured to an electronic module (e.g., the electronic module 22 shown in FIG. 1), such as a circuit card, or to another body. A set of attachment pieces, including a first end wedge 108, a second end wedge 112, as well as first, second, and third inner wedges 116, 120, 124 disposed between the first and second end wedges 116, 120, can be arranged along the rail 104. In some examples, the retainer 100 may include any number of the inner wedges including one, two, three, four, five, six, or more inner wedges. As described below, one or more of the wedges 108, 116, 120, 124 may be movable along or away from the rail 104 between an installed configuration (as shown in FIG. 2) and uninstalled configuration (as shown in FIG. 10). The one or more wedges 108, 116, 120, 124 may be moved axially or radially relative to an extension axis 128, which extends through a center of the rail 104, while the second end wedge 112 may be generally fixed relative to the rail 104. More specifically, the wedges 108, 116, 120, 124 may be configured to move away from the second end wedge 112 in an extension direction that is axial relative to the extension axis 128, and one or more of the wedges 108, 116, 120,124 may be configured to move away from the rail 104 in an expansion direction that is radial relative to the extension axis 128. One or more of the wedges 108, 116, 120, 124 may also be configured to move toward the rail, opposite the expansion direction, or toward the second wedge 112 opposite the extension direction (i.e., in a compression direction).

Each of the wedges 108, 112, 116, 120, 124 generally includes at least one ramped end portion. As depicted, for example, the end wedges 108, 112 each include a single ramped end portion. Specifically, the end wedges 108, 112 include first and second ramped end portions 132, 136, respectively. Additionally, the inner wedges 116, 120, 124 can each include two ramped end portions disposed at axially opposite ends of the inner wedges 116, 120, 124. For example, the first inner wedge 116 includes a third ramped end portion 140 and a fourth ramped end portion 144, and the second inner wedge 120 includes a fifth end portion 148 and a sixth end portion 152.

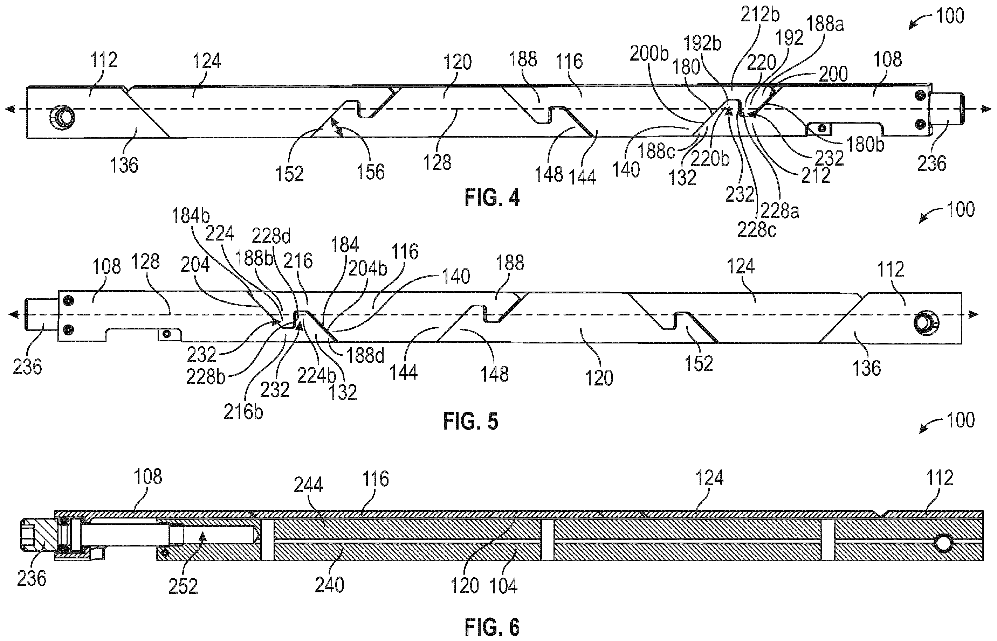

Referring to FIG. 4, each of the ramped end portions of the wedges 108, 112, 116, 120, 124 (e.g., the ramped end portions 132, 136, 140, 144, 148, 152) may define internal end angles 156, which may each be measured between a respective ramped end portion and an axis that extends parallel to the extension axis 128, or relative to the extension axis 128. In some examples, the internal end angles 156 may each be about 45 degrees. However, in other examples, the internal end angles 156 may be between about 30 degrees and about 60 degrees, or between about 20 degrees and about 70 degrees. Additionally, in some examples, one or more of the internal end angles 156 of the ramped end portions of the wedges 108, 112, 116, 120, 124 may not define the same angle.

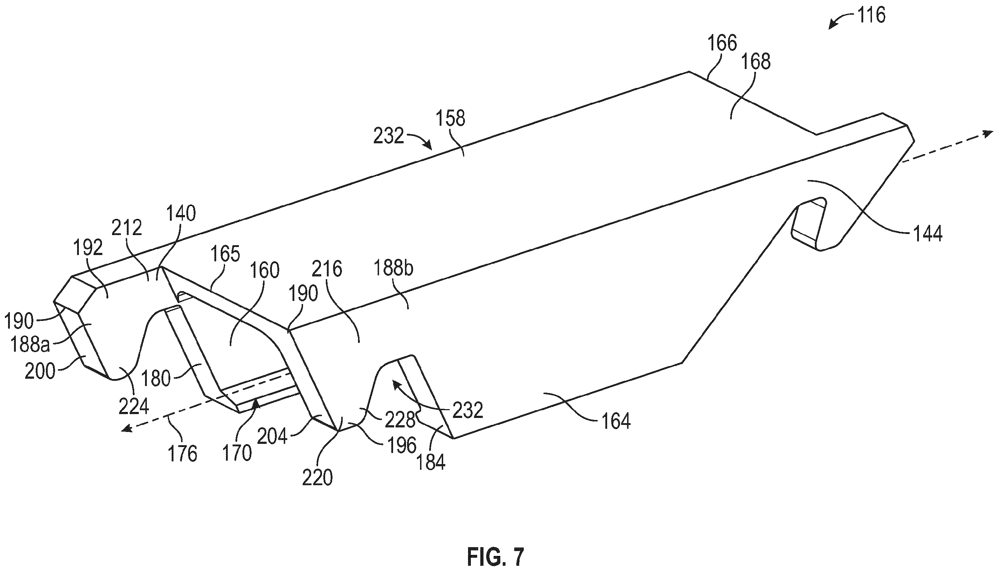

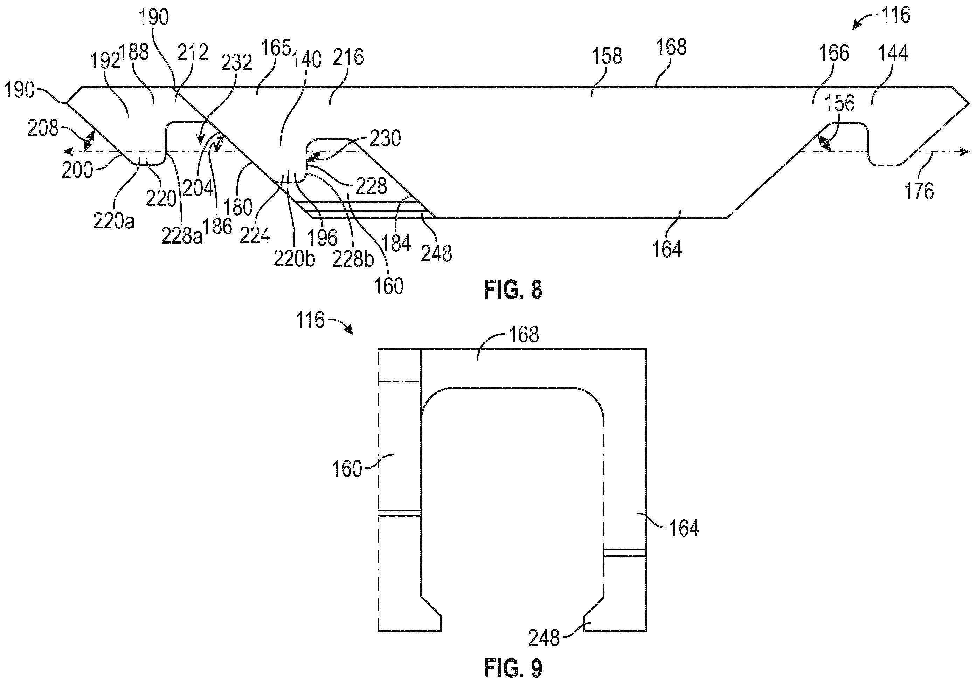

As illustrated in FIG. 7 and 9, the first inner wedge 116 may include parallel sidewalls extending between and connecting the opposing ramped end portions. For example, the first inner wedge 116 may include a first wedge body 158 that includes a first side wall 160 and a second side wall 164. The first side wall 160 and the second sidewall 164 can extend from the third ramped end portion 140 at a first end 165 of the first wedge body 158 to the fourth ramped end portion 144 at a second end 166 of the first wedge body 158. Furthermore, the side walls 160, 164 can be connected by a cross-wall 168 that extends between the first end 165 and the second end 166 of the first wedge body 158.

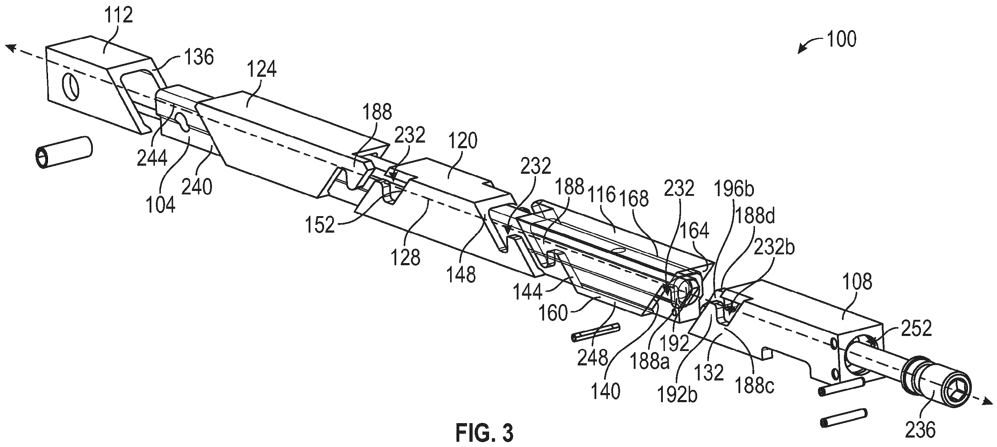

As illustrated in FIG. 3, the second and third inner wedges 120, 124 may similarly include sidewalls, connected by a cross-wall, extending between the ramped end portions thereof. Thus, as described further below, each of the wedges 116, 120, 124 may define a U-shaped internal channel to slidably receive the rail 104, with thickened flanges 248 at the free edges of the side walls (opposite the cross-walls). In some examples, the end wedges 108, 112 may also include sidewalls, connected by a cross-wall. However, the end wedges 108, 112 may only include one ramped portion (e.g., the first and second ramped portions 132, 136, respectively) extending along the sidewalls thereof. Thus, each of the wedges 108, 112, 116, 120, 124 may define a U-shaped internal channel to slidably receive the rail 104, with thickened flanges 248 at the free edges of the side walls 160, 164, opposite the cross-wall 168.

Referring to FIG. 8, in some examples, a center axis 176 (e.g., a wedge axis) may extend through a center of an internal channel 170 of the first inner wedge 116 that is defined by the first side wall 160, the second side wall 164, and the cross-wall 168. Specifically, the center axis 176 extends from the first end 165 to the second end 166 of the first inner wedge 116. In some examples, the first side wall 160 and the second side wall 164 are staggered relative to one another along the center axis 176. Specifically, the first side wall 160 may extend farther than the second side wall 164 in a first axial direction relative to the center axis 176, while the second side wall 164 may extend farther than the first side wall 160 in a second axial direction that is opposite the first axial direction. Consequently, the first inner wedge 116 may be asymmetrical about a center plane, which may extend parallel to the first side wall 160 and along the center axis 176 to bisect the first inner wedge 116 (e.g., to bisect the width of the cross-wall 168). In other examples, the first inner wedge 116 may be asymmetrical about the center plane that extends radially from the center axis 176, or the extension axis 128, along the expansion direction.

As discussed above, each of the inner wedges 116, 120, 124 may include ramped end portions, disposed on opposite ends of the inner wedges 116, 120, 124. Sill referring to FIG. 8, in some examples, the ramped end portions of the inner wedges 116, 120, 124 may include ramps (e.g., body ramps) along the ends of the side walls thereof. For example, the ramped end portions 140, 144 of the first inner wedge 116 may include ramps at axial ends of the first side wall 160 and the second side wall 164. Specifically, a first body ramp 180 of the third ramped end portion 140 may extend along the first side wall 160 at the first end 165 of the first inner wedge 116. Additionally, a second body ramp 184 of the third ramped end portion 140 may extend along the second side wall 164 at the first end 165 of the first inner wedge 116.

In some examples, the first and second body ramps 180, 184 may only extend along a portion of the first and second side walls 160, 164, respectively. For example, the first and second body ramps 180, 184 may extend toward the cross-wall 168 from the free edges of the first and second side walls 160, 164, respectively, disposed opposite the cross-wall 168. Furthermore, the first and second body ramps 180, 184 may extend only part way from the free edges to the cross-wall 168.

In some examples, the first body ramp 180 and the second body ramp 184 may each be angled with respect to the extension axis 176 at a body ramp angle 186. In some examples, the body ramp angle 186 may be equal to the internal end angle 156, as the first body ramp 180 and the second body ramp 184 form a first section of the third ramped end portion 140.

In some examples, similar to the third ramped end portion 140, the fourth ramped end portion 144 may be defined by two ramps (e.g., body ramps) extending along the first and second side walls 160, 164 at the second end 166 of the first inner wedge 116. The two ramps extending along the first and second side walls 160, 164 at the second end 166 of the first inner wedge 116 may also be angled with respect to the extension axis 176 at the internal end angle 156. In some examples, the ramped end portions of one or more of the other wedges 108, 112, 120, 124 may also be defined by two ramps extending along ends of sidewalls thereof.

Similar to the first and second side walls 160, 164, the first body ramp 180 and the second body ramp 184 of the third ramped end portion 140 can be staggered axially along the center axis 176. Consequently, the third ramped end portion 140 may be asymmetrical about the center plane. The fourth ramped end portion 144 may similarly be asymmetrical about the center plane. Additionally, each of the inner wedges 116, 120, 124 may be similarly have staggered sidewalls and staggered ramped end portions.

In some examples, one or more of the wedges 108, 116, 120, 124 can include one or more interlocking features 188 extending from one or more of the ramped end portions of the respective wedges 108, 116, 120, 124. For example, as illustrated in FIG. 8, the first inner wedge 116 includes the interlocking features 188 extending from the third ramped end portion 140. The interlocking features 188 of the third ramped end portion 140 includes a first interlocking feature 188a and second interlocking feature 188b. The first interlocking feature 188a can extend from the first body ramp 180 and the second interlocking feature 188b can extend from the second body ramp 184. Similar to the body ramps 180, 184 the first and second interlocking features 188a, 188b can be staggered axially along the center axis 176. More specifically, distal ends 190 of the first interlocking feature 188a and the second interlocking feature 188b (e.g., opposite the first body ramp 180 and the second body ramp 184, respectively) can be offset from one another relative to the center axis 176, or relative to the extension axis 128. Consequently, the interlocking features 188a, 188b may be asymmetrical about the center plane. As described further below, the interlocking features 188a, 188b extending from the third ramped end portion 140 can engage interlocking features extending from ramped end portions of one or more of the wedges 108, 120, 124 to move the retainer 100 between a plurality of configurations.

In some examples, the second end wedge 112 may not include the interlocking features 188. Furthermore, each of the other wedges 108, 116, 120, 124 can include the interlocking features 188 extending from the respective ramped end portions.

In some examples, the interlocking features 188a, 188b include a first hook 192 and a second hook 196, respectively. More specifically, the first hook 192 can extend from the first body ramp 180 and the second hook 196 can extend from the second body ramp 184. Similar to the staggering of the first body ramp 180 and the second body ramp 184, the first hook 192 and the second hook 196 are staggered relative to the center axis 176. Specifically, as illustrated in FIG. 8, the first hook 192 may extend farther in the first axial direction than the second hook 196. Referring briefly to FIG. 3, one or more of the ramped end portions of the wedges 108, 116, 120, 124 can include a set of interlocking features 188 (e.g., hooks) that are substantially identical to the first hook 192 and the second hook 196 described herein.

Referring again to FIG. 8, in some examples, distal ends 190 of the first and second interlocking features 188a, 188b may each include distal ramps. Specifically, the first hook 192 may include a first hook ramp 200 (e.g., first distal ramp) axially opposite the first body ramp 180 relative to the center axis 176, and the second hook 196 may include a second hook ramp 204 (e.g., second distal ramp) axially opposite the second body ramp 184 relative to the center axis 176.

Referring again to FIG. 8, in some examples, distal ends 190 of the first and second interlocking features 188a, 188b may be angled with respect to the center axis 176. For example, the first hook ramp 200 and the second hook ramp 204 may each define a hook angle 208 with respect to the center axis 176. In some examples, the hook angles 208 may each be about 45 degrees. However, in other examples, the hook angles 208 may be between about 30 degrees and about 60 degrees, or between about 20 degrees and about 70 degrees. Furthermore, the hook angle 208 between the first hook ramp 200 and the center axis 176 may be the same as the hook angle 208 between the second hook ramp 204 and the center axis 176. In such examples, as illustrated in FIG. 8, the first hook ramp 200 and the second hook ramp 204 may each be substantially parallel to one another. However, in other examples, the hook angle 208 between the first hook ramp 200 and the center axis 176 may be different than the hook angle 208 between the second hook ramp 204 and the center axis 176. In such examples, the first and second hook ramps 200, 204 may not be parallel to one another.

In some examples, the hook angles 208 may be equal to the internal end angle 156, as the first and second hook ramps 200, 204 may form a second section of the third ramped end portion 140. In such examples, the hook angles 208 may be the same as the body ramp angles 186, and the first and second hook ramps 200, 204 may be parallel to the first and second body ramps 180, 184. However, in other examples, the first and second hook ramps 200, 204 may be non-parallel to the first and second body ramps 180, 184.

As illustrated in FIG. 8, in some examples, one or more of the hook ramps 200, 204 may be axially aligned with one or more of the body ramps 180, 184. More specifically, the first body ramp 180 may be axially aligned with the second hook ramp 204 along the center axis 176 or the extension axis 128. Furthermore, the ramped end portions 132, 140, 144, 148, 152 may also include axially aligned body and hook ramps, similar to the interlocking features 188a, 188b. In such examples, the alignment of the body and hook ramps 180, 204 can aid the engagement of the interlocking features 188 during expansion and extension of the retainer 100. Furthermore, in some examples, the alignment of the body and hook ramps 180, 204 can increase manufacturing efficiency.

In different examples, a wide variety of hook shapes are possible. Referring again to FIG. 8, the first and second hooks 192, 196 can include a first shank 212 and a second shank 216, respectively. The first shank 212 and the second shank 216 can extend from the first and second body ramps 180, 184, respectively. In some examples, the first shank 212 and the second shank 216 may extend from the first and second body ramps 180, 184, respectively, adjacent to the cross-wall 168, and may extend axially relative to the center axis 176. As illustrated in FIG. 8, the first shank 212 may be wider than the second shank 216 in a direction that is parallel to the first side wall 160. However, as clarified below, in other examples, the first and second shanks 212, 216 may define the same width.

In some examples, a first projection 220 and a second projection 224 extend from the first shank 212 and the second shank 216, respectively. Specifically, as illustrated in FIG. 8, the first projection 220 and the second projection 224 may extend from the first and second shanks 212, 216, respectively, parallel to the first and second side walls 160, 164 and toward the center axis 176 (e.g., in parallel with the expansion direction), or away from the cross wall 168. In some examples, the projections 220, 224 may include inner engagement surfaces 228 (e.g., edges). For example, the first projection 220 can include a first inner engagement surface 228a (or, simply, inner surface 228a) and the second projection 224 can include a second inner engagement surface 228b (or, simply, inner surface 228b). In some examples, the first inner surface 228a can be disposed between the distal end 190 of the first hook 192 (e.g., the first hook ramp 200), and the first body ramp 180. Furthermore, the second inner surface 228b can be disposed between the distal end 190 of the second hook 196 (e.g., the second hook ramp 204), and the second body ramp 184. In such examples, the inner surfaces 228a, 228b of the first and second projections 220, 224, can face the first and second body ramps 180, 184, respectively, and can be the surfaces (e.g., edges) of the projections 220, 224, respectively, that are disposed the closest to the first and second body ramps 180, 184, respectively.

As illustrated in FIG. 8, the inner engagement surfaces 228a, 228b may extend at an inner surface angle 230 relative to the center axis 176. For example, the inner surfaces 228a, 228b may extend at the inner surface angle 230 that is about 90 degrees (e.g., perpendicular) relative to an axis that is parallel to the center axis 176, or relative to the center axis 176. In such examples, the inner surfaces 228a, 228b may extend substantially perpendicularly from the first and second shanks 212, 216, respectively. Furthermore, the inner surfaces 228a, 228b may extend substantially parallel relative to one another. In such examples, as discussed below, the inner surfaces 228a, 228b can be non-parallel with one or more of the body ramps 180, 184 and the hook ramps 200, 204. As discussed further below, the inner surfaces of each of the wedges 108, 116, 120, 124 may be parallel to another, which may provide mechanical advantages during adjustment of the retainer 100 between the plurality of configurations.

In other examples, as described further below, the first and second projections 220, 224 may be differently shaped. For example, the inner engagement surfaces 228 of the first and second projections 220, 224 may be curved, or the first and second projections 220, 224 may extend at an oblique angle from the first and second shanks 212, 216, respectively, or relative to the center axis 176 (i.e., may be inner engagement ramps).

As described above, the distal ends 190 of the hooks 192, 196 may include the first and second hook ramps 200, 204, respectively. Furthermore, the projections 220, 224 may extend axially from the shanks 212, 216 to the distal ends of the hooks 192, 196. In such examples, the hook ramps 200, 204 may be distal ramps, disposed axially opposite the inner engagement surfaces 228, 228b, respectively, along the projections 220, 224, respectively. As illustrated in FIG. 8, the inner surfaces 228, 228b may be non-parallel with the hook ramps 200, 204, respectively. More specifically, the hook angles 208 of the hook ramps 200, 204, may be different than the inner surface angles 230 of the inner surfaces 228, 228b, respectively. As also illustrated in FIG. 8, the inner surfaces 228, 228b may be non-parallel with the body ramps 180, 184, respectively. More specifically, the body ramp angle 186 of the body ramps 180, 184, may be different than the inner surface angles 230 of the inner surfaces 228, 228b, respectively.

The first and second hook 192, 196 may each include recesses 232 that are formed between the first and second projections 220, 224, the first and second shanks 212, 216 and the first and second body ramps 180, 184, respectively. As illustrated in FIG. 8, the first and second projections 220, 224, the first and second shanks 212, 216 and the first and second body ramps 180, 184, respectively, may form the recesses 232 having solid sides corresponding to a trapezoidal shape, or other non-parallelogram. Specifically, opposing solid sides of the recesses 232 (e.g., defined by the inner surfaces 228a, 228b of the first and second projections 220, 224 and the first and second body ramps 180, 184, respectively) may be non-parallel or may otherwise define an oblique angle relative to one another, as described above.

In some examples, one or more of the ramped end portions 132, 140, 144, 148, 152 may include the interlocking features similar to or identical to the interlocking features 188. However, as described below, the hooks of the one or more of the ramped end portions 132, 140, 144, 148, 152 may be inverted relative to the hooks 192, 196 relative to the extension axis 128. Referring briefly to FIGS. 4 and 5, the first end wedge 108 may generally include features similar to the first inner wedge 116 including but not limited to third and fourth sidewalls, a second cross-wall, and third and fourth body ramps 180b, 184b. Furthermore, the first end ramp portion 132 of the first end wedge 108 can include third and fourth interlocking features 188c, 188d having third and fourth hooks 192b, 196b, third and fourth hook ramps 200b, 204b, third and fourth shanks 212b, 216b, third and fourth projections 220b. 224b, and third and fourth inner surfaces 228c, 228d. Additionally, the first end wedge 108 can include recesses 232b formed between the projections 220b, 224b, the shanks 212b, 216b and the body ramps 180b, 184b, respectively. However, unlike the first inner wedge 116, the third and fourth shanks 212b, 216b may extend from the third and fourth body ramps 180b, 184b, respectively, adjacent to free edges of the first end wedge 108, disposed opposite the second cross-wall. Furthermore, the third and fourth projections 220b, 224b may extend from the shanks 212b, 216b, respectively, toward the second cross-wall. In such examples, the hooks 192b, 196b may inverted relative to the hooks 192, 196. Consequently, as illustrated in FIGS. 4 and 5, in such examples, the projections 220, 224 of the first inner wedge 116 may be received in the recesses 232b of the first end wedge 108, and the projections 220c, 220d of the first end wedge 108 may be received in the recesses 232 of the first inner wedge 116. As described further below, the ramps 180, 184, 200, 204 of the first inner wedge 116 may slide along the ramps 180b, 184b, 200b, 204b of the first end wedge 108 as the wedges 116, 108 are adjusted between a relaxed configuration and an expanded configuration. Furthermore, the inner surfaces 228, 228b of the first inner wedge 116 may engage the inner surfaces 228a, 228b of the first end wedge 108 as the wedges 116, 108 are adjusted between a plurality of states or configurations.

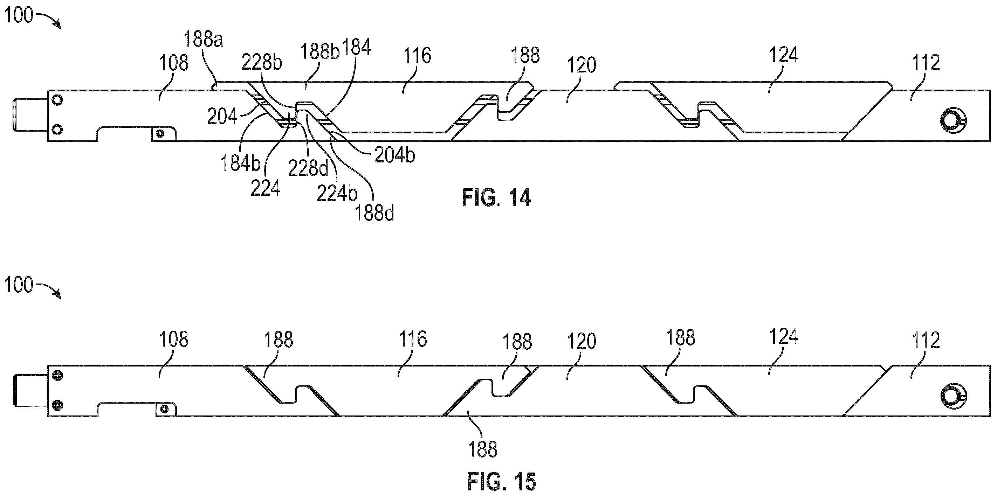

As illustrated in FIG. 4 the recesses 232 of the first and second hooks 192, 196 receive and retain the interlocking features 188 of adjacent wedges (e.g., projections of hooks thereof) when the retainer 100 is in the uninstalled configuration. As illustrated in FIGS. 14 and 15, and described further below, the interlocking features 188 of adjacent wedges 108, 116, 120, 124 (e.g., hooks thereof) may engage one another to aid in the movement of the retainer 100 from the installed configuration to the uninstalled configuration.

Referring still to FIG. 4, generally, the ramped ends of adjacent wedges (e.g., of the first end wedge 108 and the first inner wedge 116 or the first inner wedge 116 and the second inner wedge 120) are placed in contact with each other. For example, the body ramps 180, 184 of the first inner wedge 116, may contact the hook ramps 200b, 204b of the first end wedge 108, respectively, and the hook ramps 200, 204 of the first inner wedge 108, may contact the body ramps 180b, 184b of the first end wedge 108, respectively. Accordingly, the wedges 108, 112, 116, 120, 124, when in an extended (or relaxed) state, collectively define an extended (or relaxed) distance, measured substantially parallel to the extension axis 128, and an extended-state (or relaxed-state) width, measured substantially perpendicular to the extension axis 128 (i.e., in an expansion direction).

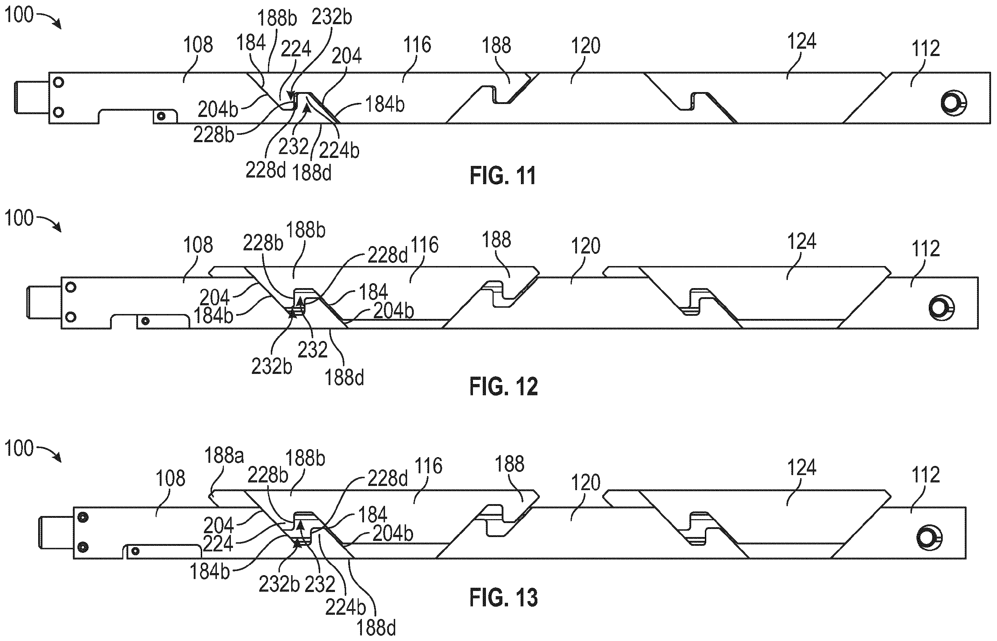

In different examples, different adjustment devices can be used, including threaded, cammed, or other applicable devices. As illustrated in FIG. 2, an adjustment device for adjusting a length and width of the retainer 100 includes a screw 236 (e.g., an adjustment device) extending into the first end wedge 108 to engage internal threading of the rail 104 (as illustrated in FIG 6). Referring briefly to FIGS. 10 and 13, when the screw 236 is tightened, the retainer 100 is generally compressed in a compression direction, opposite the extension direction, such that the wedges 108, 112, 116, 120, 124 collectively define a compressed distance that is shorter than the extended distance (as shown in FIGS. 2 and 4). Due to the interaction of the respective pairs of ramped end portions, compression of the retainer 100 also results in a compressed-state width that is larger than the extended-state width (see FIGS. 2 and 4). It can be seen in FIG. 10 and 13, for example, that compression of the retainer 100 results in the inner wedges 116, 124 moving laterally away from the rail 104 in the expansion direction (i.e., upward from the perspective of FIG. 13) to define the compressed-state width. Accordingly, where a solid body (e.g., a side wall of a slot on a cold plate as illustrated in FIG. 1) is disposed laterally adjacent to the retainer 100 (i.e., above the retainer 100, from the perspective of FIG. 13), the increased compressed-state width may cause the wedges 120, 124 to press against the solid body and thereby provide a retaining force for the electronic module.

FIG. 3 depicts the retainer 100 in an exploded view, and including the first inner wedge 116 as transparent, to illustrate how the wedges 108, 112, 116, 120, 124 are retained and moved relative to the rail 104. In order for the rail 104 to retain the various wedges 108, 112, 116, 120, 124, the rail 104 includes a neck portion 240 and a relatively wider retention portion 244. Threaded holes or other attachment devices (as illustrated in FIG. 6) can be included in the neck portion 240, in order to attach the rail 104 to another body (e.g., an electronic module such as a circuit card).

Side walls of the various wedges 108, 112, 116, 120, 124 such as the side walls 160, 164 of the first inner wedge 116 (as illustrated in FIG. 9), are generally spaced apart from each other by a distance (e.g., measured parallel to cross-walls of the wedges) that is larger than the widths of the neck portion 240 and the retention portion 244. Accordingly, the wedges 108, 112, 116, 120, 124 can be slid axially along the rail 104 during installation and/or adjustment. Further, retaining flanges, such as the flanges 248, disposed along the free edges side walls 160, 164, opposite the cross-wall 168, are generally spaced apart from each other by a distance (e.g., measured parallel to cross-walls of the wedges) that is larger than the width of the neck portion 240 but smaller than the width of the retention portion 244. Accordingly, the flanges 248 (and other similar flanges of the wedges 108, 112, 120, 124) can prevent the wedges 108, 112, 116, 120, 124 from moving laterally (i.e., upward, from the perspective of FIG. 4) off of the rail 104.

As illustrated in FIG. 6, a threaded tube 252 can be formed within the rail 104, in order to receive the screw 236. When the screw 236 is tightened, the screw 236 can engage threads within the tube 252 in order to move into the tube 252. In this way, the screw 236 can be caused to bear on an end surface of the first end wedge 108 and thereby generally compress the retainer 100 along the rail 104. Accordingly, by tightening the screw 236, the various adjacent ramped end portions of the wedges 108, 112, 116, 120, 124 can be urged together such that the wedges 108, 116, 120, 124 are moved toward the second end wedge 112 and opposite the extension direction. Furthermore, by tightening the screw 236, the various adjacent ramped end portions of the wedges 108, 112, 116, 120, 124 can be urged together such that the wedges 116, 124 are moved away from the rail 104 and in the expansion direction. For example, the ramps 180, 184, 200, 204 of the first inner wedge 116 can contact and slide along the ramps 200b, 204b, 180b, 184b, respectively, of the first end wedge 108 as the first inner wedge 116 moves in the expansion direction (as illustrated in FIGS. 11-13). As such, tightening the screw 236 can simultaneously move the wedges 116, 124 in the expansion direction, and opposite the extension direction, while moving the wedges 108, 112, 120 opposite the extension direction.

In some examples, various pins or similar bodies can be used to further secure one or more of the wedges 108, 112, 116, 120, 124 to the rail 104. As can be seen in particular in FIGS. 2 and 3, various pins and screws can secure the first or second end wedges 108, 112 to the rail 104.

FIGS. 11-13 illustrate the retainer 100 transitioning from an uninstalled configuration to an installed configuration. With reference to FIG. 11, for example, when the retainer 100 is in the uninstalled configuration, a length of the retainer 100 defines the extended distance, and the screw 236 extends only a small amount into the threaded tube 252 of the rail 104. With reference to FIGS. 12 and 13, as the screw 236 is moved deeper into the threaded tube 252, the first inner wedge 116 and the third inner wedge 124 are moved laterally (i.e., upward, from the perspective of FIGS. 12 and 13) away from the rail 104 and the extension axis 128 in the expansion direction. Additionally, each of the wedges 108, 116, 120, 124 are moved along the rail 104 opposite the extension direction along the extension axis 128 (i.e., to the right, from the perspective of FIGS. 12 and 13).

As depicted in FIGS. 11-13, when the screw 236 is tightened, the retainer 100 can be compressed to the installed configuration, such that the inner wedges 116, 124 are moved laterally away from the rail 104 and the extension axis 128. In this way, the retainer 100 may be used to secure an electronic module to another body. Specifically, as the screw 236 is tightened, the ramped end portions of adjacent wedges engage, and slide relative to one another to force the first inner wedge 116 and the third inner wedge 124 to move laterally away from the extension axis 128. In some examples, engagement of the first ramped end portion 132 and the third ramped end portion 140 include the sliding of the first and second hook ramps 200, 204 of the first and second hooks 192, 196 along the first ramped end portion 132. Specially, the first and second hook ramps 200, 204 may contact and slide along the body ramps 180b, 184b, respectively, of the first ramped end portion 132 formed along the sidewalls of the first end wedge 108, and the first and second body ramps 180, 184 may contact and slide along the hook ramps 200b, 204b, respectively, of the first ramped end portion 132.

As depicted in FIGS. 14 and 15, when the screw 236 is loosened, the retainer 100 can be extended to the uninstalled configuration, such that the inner wedges 116, 124 are moved laterally toward the rail 104 and the extension axis 128, opposite the expansion direction, and such that each of the wedges 108, 116, 120, 124 are moved along the rail 104 in the extension direction, axially relative to the extension axis 128 (i.e., to the left, from the perspective of FIGS. 14 and 15). In this way, the retainer 100 may be uninstalled so that an electronic module attached to the retainer 100 (e.g., electronic module 22, as illustrated in FIG. 1) can be removed from a body (e.g., body 26, as shown in FIG. 1).

Still referring to FIG. 14 and 15, as the screw 236 is loosened, the first end wedge 108 is urged in the extension direction. As the first end wedge 108 is urged in the extension direction, the interlocking features 188c, 188d extending from the first end ramp portion 132 of the first end wedge 108 engage the interlocking features 188a, 188b of the third end ramp portion 140 of the first inner wedge 116 (e.g., the first hook 192 and the second hook 196). The interlocking features 188c, 188d can engage the interlocking features 188a, 188b to provide a positive retraction force as the first end wedge 108 is moved in the extension direction. Furthermore, as the first end wedge 108 is disengaged from the first inner wedge 116, the ramps 180, 184, 200, 204 of the first inner wedge 116 can slide along the ramps 200b, 204b, 180b, 184b, respectively, of the first end wedge 108 to move the first inner wedge 116 in the extension direction and opposite the expansion direction to the uninstalled configuration.

In some examples, the hooks 192, 196 of the interlocking features 188c, 188d of the first end ramp portion 132 contact and engage the hooks 192b, 196b of the interlocking features 188a, 188b of the third ramp portion 140, providing a positive retraction force as the first end wedge 108 is moved in the extension direction. More specifically, the inner surfaces 228c, 228d of the hooks 192b, 196b of the first ramp portion 132 may contact and engage the inner surfaces 228c, 228 of the hooks 192, 196 of the third ramp portion 140. As illustrated in FIGS. 4 and 5, the inner surfaces 228a, 228b of the hooks 192, 196 and the inner surfaces 228c, 228d of the hooks 192b, 196b can each be oriented perpendicular relative to the extension axis 128, and substantially parallel to one another. In such examples, the engagement of the inner surfaces 228a, 228b, 228c, 228d that are oriented perpendicular to the extension axis 128 may exert the positive retraction force onto one another that unexpectedly provides a mechanical advantage over the prior art. More specifically, the normal force exerted by the inner surfaces 228a, 228b of the first end wedge 108 on the inner surfaces 228, 228b of the first inner wedge 116 may beneficially be stronger than the prior art, which relies on no positive retraction forces or friction forces to pull the wedges 108, 116, 120, 124 in the extension direction or opposite the expansion direction.

The engagement between the aligned interlocking features 188 of the first and third end ramp portions 132, 140 may pull the first inner wedge 116 in the extension direction, aiding the disengagement of the first inner wedge 116 from the second inner wedge 120 and aiding the transition of the retainer 100 from the installed configuration to the uninstalled configuration. Additionally, the interlocking features 188 of the fourth end ramp portion 144 of the first inner wedge 116 can engage the aligned interlocking features 188 of the fifth end ramp portion 148 of the second inner wedge 120 and may also pull the second inner wedge 120 in the extension direction. More specifically, inner surfaces of the hooks of the interlocking features 188 of the end ramp portions may engage to provide the positive retraction force across each of the wedges 108, 116, 120, 124. The engagement between interlocking features 188 of each adjacent wedge can cause a cascade of pulling, in the extension direction, of each successive one of the inner wedges 116, 120, 124. This can dislodge adjacent wedges from each other and aid the transition of the retainer 100 from the installed configuration to the uninstalled configuration.

As noted above, interlocking features can be asymmetrical in some examples, including so that hooks at a particular ramped end of a wedge extend to different axial lengths, or so that hooks on a shared side of a wedge extend by different axial lengths relative to the respective axial end of the wedge. As shown in FIGS. 10-15, this can result in an overlap of interlocking features of a first wedge with the body (or interlocking features) of a second, adjacent wedge, with corresponding benefits for alignment and stability. Further, such asymmetrical arrangements can help to better distribute forces on the wedges during expansion operations, with corresponding improvements in overall strength and ability to overcome sticking forces. For example, axially staggered lengths can allow for improved overall strength on wedges for which the thickened flange for retention of the wedges on a rail is not included on a hook or interlocking features (see, e.g., flange 248, FIG. 9).

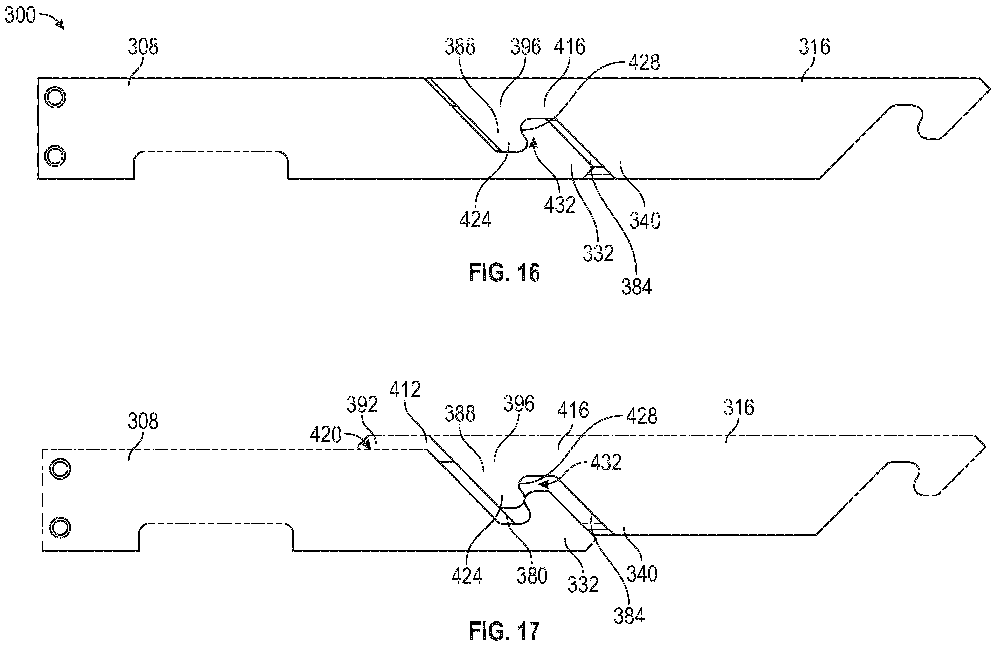

In some examples, a retainer may include alternate interlocking features. In this regard, for example, FIGS. 16 and 17 illustrate another example of a retainer 300. The retainer 300 of FIGS. 16 and 17 may generally include similar features as the retainer 20 of FIG. 1 and the retainer 100 FIGS. 2-15, including but not limited to a first end wedge 308, a first inner wedge 316, a first end ramped portion 332, a third end ramped portion 340, and interlocking features 388 including a first hook 392 and a second hook 396 extending from a first ramp 380 and a second ramp 384 of the third end ramped portion 340. Thus, discussion of retainers 20, 100 above also generally applies to similarly numbered or named components of the retainers 300 (and vice versa).

Referring to FIGS. 16 and 17, in some examples, the retainer 300 may include an alternate style of the interlocking features 388. As similarly discussed above, the interlocking features 388 of the third end ramped portion 340 (and the ramped portions of one or more of the other wedges) include the first hook 392 and the second hook 396 extending from the first ramp 380 and the second ramp 384, respectively. The first and second hooks 392, 396 include a first shank 412 and a second shank 416, respectively, extending from the first and second ramps 380, 384, respectively.

In some examples, a first projection 420 and a second projection 424 extend from the first shank 412 and the second shank 416, respectively. Specifically, as illustrated in FIG. 17, inner sides 428 (e.g., edges) of the first and second projections 420, 424, disposed closest to the first and second ramps 380, 384, respectively, may extend obliquely from the first and second shanks 412, 416, respectively. In some examples, the inner sides 428 of the first and second projections 420, 424 may be substantially parallel to the first and second ramps 380, 384.

The first and second hook 392, 396 may each include recesses 432 that are formed between the first and second projections 420 424, the first and second shanks 412, 416 and the first and second ramps 380, 384, respectively. As illustrated in FIG. 17, the first and second projections 420, 424, the first and second shanks 412, 416, and the first and second ramps 380, 384, respectively, may form the recesses 432 having solid sides corresponding to a parallelogram shape. Specifically, opposing solid sides of the recesses 432 (e.g., defined by the inner sides 428 of the first and second projections 420, 424 and the first and second ramps 380, 384, respectively) may be substantially parallel.

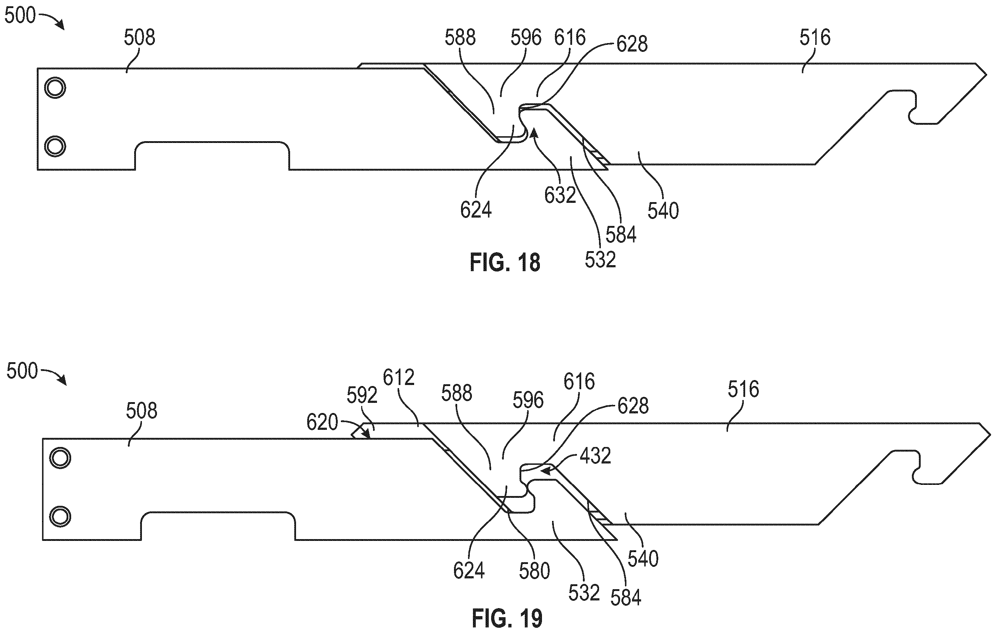

In some examples, a retainer may include alternate interlocking features. In this regard, for example, FIGS. 18 and 19 illustrate another example of a retainer 500. The retainer 500 of FIGS. 18 and 19 may generally include similar features as the retainer 20 of FIG. 1, the retainer 100 FIGS. 2-15, and the retainer 300 of FIGS. 16, including but not limited to a first end wedge 508, a first inner wedge 516, a first end ramped portion 532, a third end ramped portion 540, and interlocking features 588 including a first hook 592 and a second hook 596 extending from a first ramp 580 and a second ramp 584 of the third end ramped portion 540. Thus, discussion of retainers 20, 100, 300 above also generally applies to similarly numbered or named components of the retainer 500 (and vice versa).

Referring to FIGS. 18 and 19, in some examples, the retainer 500 may include an alternate style of the interlocking features 588. Similar to above, the interlocking features 588 of the third end ramped portion 540 (and the ramped portions of one or more of the other wedges) include the first hook 592 and the second hook 596 extending from the first ramp 580 and the second ramp 584, respectively. The first and second hooks 592, 596 include a first shank 612 and a second shank 616, respectively, extending from the first and second ramps 580, 584, respectively.

In some examples, a first projection 620 and a second projection 624 extend from the first shank 612 and the second shank 616, respectively. Specifically, as illustrated in FIG. 19, inner sides 628 (e.g., edges) of the first and second projections 620, 624, disposed closest to the first and second ramps 580, 584, respectively, may extend curvedly from the first and second shanks 612, 616, respectively. For example, the inner sides 628 may define one or more inflection points.

The first and second hook 592, 596 may each include recesses 632 that are formed between the first and second projections 620 624, the first and second shanks 612, 616 and the first and second ramps 580, 584, respectively. As illustrated in FIG. 19, the first and second projections 620, 624, the first and second shanks 612, 616, and the first and second ramps 580, 584, respectively, may form the recesses 632 having solid sides corresponding to a trapezoidal shape having a curved side. Specifically, opposing solid sides of the recesses 632 (e.g., defined by the inner sides 628 of the first and second projections 620, 624 and the first and second ramps 580, 584, respectively) may be non-parallel, and as described above, the inner sides 628 defined by the first and second projections 620, 624 may be curved.

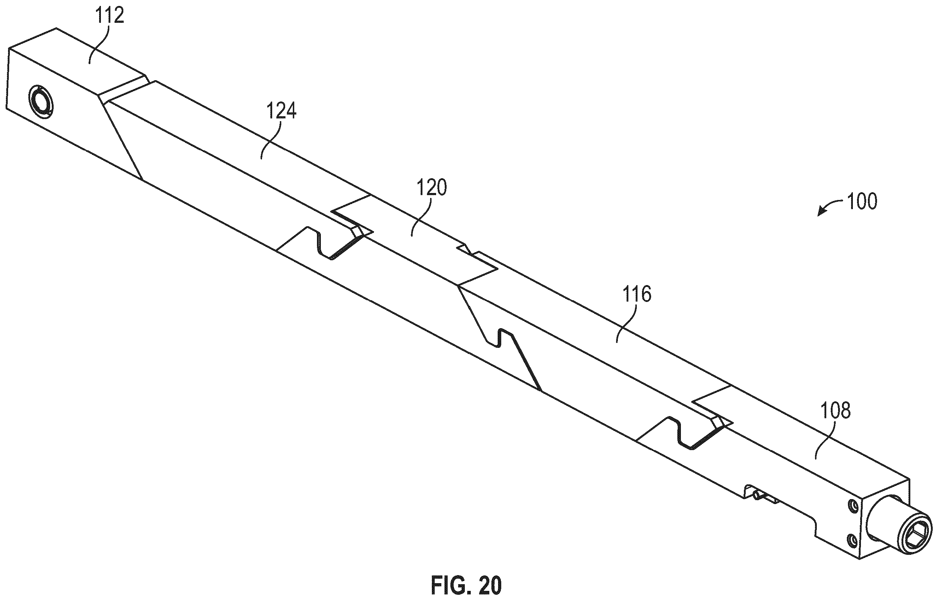

In some examples, the retainer 100 may include variations in lengths and widths of certain components of the wedges 108, 112, 116, 120, 124. For example, as illustrated in FIGS. 20-24 in some examples, the shanks 212, 216 may vary in width. Specifically, the first shank 212 may be define the same width as the second shank 216 in a direction that is parallel to the first side wall 160. Furthermore, in some examples, the length of the shanks 212, 216 can vary. For example, the shanks 212, 216 illustrated in FIGS. 23 and 24 may be shorter than the shanks 212, 216 illustrated in FIGS. 7-9. Additionally, in some examples, the staggering of the hooks 192, 196 may vary. For example, an axial distance between the hooks 192, 196 and the body ramps 180, 184 illustrated in FIGS. 23 and 24 (e.g., measured axially along the center axis 176) may be shorter than the axial distance between the hooks 192, 196 and the body ramps 180, 184 illustrated in FIGS. 7-9.

Thus, examples of the disclosure provide for an improved installation and removal of electronic modules. Through the use of interlocking features, adjacent wedges may be configured to provide a cascade of positive retractive forces to ensure the retainer is movable from an installed configuration to an uninstalled configuration.

As used herein, unless otherwise limited or specified, "substantially identical" or "substantially similar" refers to two or more components or systems that are manufactured or used according to the same process and specification, with variation between the components or systems that are within the limitations of acceptable tolerances for the relevant process and specification. For example, two components can be considered to be substantially identical if the components are manufactured according to the same standardized manufacturing steps, with the same materials, and within the same acceptable dimensional tolerances (e.g., as specified for a particular process or product).

Unless otherwise limited or defined, "substantially parallel" indicates a direction that is within ± 12 degrees of a reference direction (e.g., within ± 6 degrees or ± 3 degrees), inclusive. Correspondingly, "substantially vertical" indicates a direction that is substantially parallel to the vertical direction, as defined relative to gravity, with a similarly derived meaning for "substantially horizontal" (relative to the horizontal direction). Likewise, unless otherwise limited or defined, "substantially perpendicular" indicates a direction that is within ± 12 degrees of perpendicular a reference direction (e.g., within ± 6 degrees or ± 3 degrees), inclusive.

Unless otherwise limited or defined, "substantially radial" indicates a direction that is within ± 12 degrees of a reference direction (e.g., within ± 6 degrees or ± 3 degrees), inclusive. Likewise, unless otherwise limited or defined, "substantially tangential" indicates a direction that is within ± 12 degrees of a reference direction (e.g., within ± 6 degrees or ± 3 degrees), inclusive.

Also as used herein, the use of "including," "comprising," or "having" and variations thereof is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

Also as used herein, unless otherwise limited or defined, "or" indicates a non-exclusive list of components or operations that can be present in any variety of combinations, rather than an exclusive list of components that can be present only as alternatives to each other. For example, a list of "A, B, or C" indicates options of: A; B; C; A and B; A and C; B and C; and A, B, and C. Correspondingly, the term "or" as used herein is intended to indicate exclusive alternatives only when preceded by terms of exclusivity, such as "either," "one of," "only one of," or "exactly one of." For example, a list of "one of A, B, or C" indicates options of: A, but not B and C; B, but not A and C; and C, but not A and B. A list preceded by "one or more" (and variations thereon) and including "or" to separate listed elements indicates options of one or more of any or all of the listed elements. For example, the phrases "one or more of A, B, or C" and "at least one of A, B, or C" indicate options of: one or more A; one or more B; one or more C; one or more A and one or more B; one or more B and one or more C; one or more A and one or more C; and one or more of A, one or more of B, and one or more of C. Similarly, a list preceded by "a plurality of' (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

Unless otherwise limited or defined, the terms "about" and "approximately," as used herein with respect to a reference value, refer to variations from the reference value of ± 20% or less (e.g., ± 15, ± 10%, ± 5%, etc.), inclusive of the endpoints of the range. Similarly, as used herein with respect to a reference value, the term "substantially equal" (and the like) refers to variations from the reference value of less than ± 5% (e.g., ± 2%, ± 1%, ± 0.5%) inclusive.

Also as used herein, unless otherwise limited or defined, "substantially identical" indicates that features or components are manufactured using the same processes according to the same design and the same specifications. In some cases, substantially identical features can be geometrically congruent.

Also as used herein, unless otherwise limited or defined, "substantially centered" indicates that a center of a feature or component relative to a reference direction is within 10% of center of another feature or component relative to the reference direction. For example, for a body having a length L relative to a first direction, a feature that is substantially centered on the body along a first direction has a center that is located at a distance of within 0.1*L of a midpoint of the body along the first direction. In contrast, unless otherwise limited or defined, "offset" indicates that a center of a feature or component is not substantially centered on another component.

Also as used herein, unless otherwise limited or defined, "integral" and derivatives thereof (e.g., "integrally") describe elements that are manufactured as a single piece without fasteners, adhesive, or the like to secure separate components together. For example, an element stamped, cast, or otherwise molded as a single-piece component from a single piece of sheet metal or using a single mold, without rivets, screws, or adhesive to hold separately formed pieces together is an integral (and integrally formed) element. In contrast, an element formed from multiple pieces that are separately formed initially then later connected together, is not an integral (or integrally formed) element.

In some implementations, devices or systems disclosed herein can be utilized, manufactured, or installed using methods embodying aspects of the invention. Correspondingly, any description herein of particular features, capabilities, or intended purposes of a device or system is generally intended to include disclosure of a method of using such devices for the intended purposes, of a method of otherwise implementing such capabilities, of a method of manufacturing relevant components of such a device or system (or the device or system as a whole), and of a method of installing disclosed (or otherwise known) components to support such purposes or capabilities. Similarly, unless otherwise indicated or limited, discussion herein of any method of manufacturing or using for a particular device or system, including installing the device or system, is intended to inherently include disclosure, as examples of the invention, of the utilized features and implemented capabilities of such device or system.

Features which are described in the context of separate embodiments may also be provided in combination in a single embodiment. Features which are, for brevity, described in the context of a single embodiment, may also be provided separately or in any suitable sub-combination, or combined as new embodiments. The applicant hereby gives notice that new claims may be formulated to one or more features and/or combinations of such features during the prosecution of the present application or of any further application derived therefrom. Features of the retainer and/or any component(s) and/or feature(s) described may be incorporated into/used in corresponding methods and vice versa.

The previous description of the disclosed examples is provided to enable any person skilled in the art to make or use the invention. Various modifications to these examples will be readily apparent to those skilled in the art, and the generic principles defined herein may be applied to other examples without departing from the spirit or scope of the invention. Thus, the invention is not intended to be limited to the examples shown herein but is to be accorded the widest scope consistent with the principles and novel features disclosed herein.

## Claims

1. A retainer (100) for securing an electronic module to a body, the retainer (100) comprising:
a rail (104) that defines an extension axis (128) extending through a center of the rail (104); and
a plurality of wedges arranged along the rail (104), the plurality of wedges being engaged with the rail (104) to be adjustable axially and radially relative to the extension axis (128), to move between a first configuration and a second configuration;
each of a first wedge (116) and a second wedge (108) of the plurality of wedges integrally including:
a wedge body (158) that defines a center axis (176) substantially parallel to the extension axis (128);
a first interlocking feature (188) extending from a first body end of the wedge body (158); and
a second interlocking feature (188) extending from the first body end and offset from the first interlocking feature (188) along the center axis (176); and
an adjustment device (236) that:
adjusts the plurality of wedges from the first configuration to the second configuration by compressing the plurality of wedges in a compression direction to urge a first ramped end portion (140) of the first wedge (116) against a second ramped end portion (132) of the second wedge (108) so that the first wedge (116) moves radially away from the rail (104) in an expansion direction; and
adjusts the plurality of wedges from the second configuration to the first configuration by expanding the plurality of wedges along an extension direction, opposite the compression direction, so that the first and second interlocking features (188) of the first wedge (116) engage, respectively, the second and first interlocking features (188) of the second wedge (108), to urge the first wedge (116) one or more of: in the extension direction, or opposite the expansion direction.

2. The retainer (100) of claim 1, wherein for each of the first and second wedges (116, 108):
a distal end of the first interlocking feature (188) that is disposed axially opposite the wedge body (158) is offset along the center axis (176) from a distal end of the second interlocking feature (188) that is disposed axially opposite the wedge body (158) along the center axis (176).

3. The retainer (100) of claim 2, wherein the first ramped end portion (140) of the first wedge (116) includes the first and second interlocking features (188) of the first wedge (116), and the second ramped end portion (132) of the second wedge (108) includes the first and second interlocking features (188) of the second wedge (108).

4. The retainer (100) of claim 1, wherein each of the first ramped end portion (140) and the second ramped end portion (132) includes, for the corresponding first or second wedge (108): a distal ramp at a distal end of the first interlocking feature (188) and a body ramp extending along the wedge body (158); and
wherein the first ramped end portion (140) being urged into the second ramped end portion (132) includes the distal ramp of each of the first and second wedges (116, 108) being urged against the body ramp of the other of the first and second wedges (116, 108).

5. The retainer (100) of claim 4, wherein for each of the first and second ramped end portions (140, 132), the distal ramp and the body ramp are axially aligned along the center axis (176).

6. The retainer (100) of claim 1, wherein the first interlocking feature (188) and the second interlocking feature (188) are asymmetrical relative to one another about a center plane extending radially from the center axis (176) along the expansion direction.

7. The retainer (100) of claim 1, wherein the first interlocking feature (188) includes a first hook (192), the first hook (192) including a first shank that extends from the first end of the wedge body (158) to a first projection,
the first projection extending from the first shank toward the center axis (176),
the first projection including a distal ramp that is disposed axially opposite the wedge body (158) along the center axis (176) and forms part of the first ramped end portion (140), the distal ramp being angled at a first angle (208) relative to the center axis (176), and
the first projection including an inner engagement surface, disposed between the distal ramp and the wedge body (158), the inner engagement surface being angled at a second angle (230) relative to the center axis (176);
wherein the first angle (208) is different from the second angle (230);
and, optionally or preferably, wherein the wedge body (158) includes a first body ramp disposed at the first body end, the first body ramp being angled at a third angle (186) relative to the center axis (176), and the third angle (186) being different from the second angle (230).

8. The retainer (100) of claim 1, wherein the first interlocking feature (188) includes a first hook (192), the first hook (192) including:
a first shank that extends from the first end of the wedge body (158) to a first projection, the first projection extending from the first shank toward the center axis (176), and
the first projection including an engagement surface, the engagement surface being oriented substantially perpendicular to the center axis (176).

9. The retainer (100) of claim 1, wherein a first end wedge (112) of the plurality of wedges, arranged at a first end of the rail (104), does not include the interlocking features (188);
and, optionally or preferably, wherein each of the plurality of wedges other than the first end wedge (112) includes the interlocking features (188).

10. The retainer (100) of claim 1, wherein the first interlocking feature (188) includes a first hook (192), the first hook (192) including a first shank that extends from the first end of the wedge body (158) to a first projection,
the first projection extending from the first shank toward the center axis (176),
the first projection including an inner engagement surface, disposed between a distal end of the first interlocking feature (188), opposite the wedge body (158), and the wedge body (158), and
wherein adjusting the wedges from the second configuration to the first configuration by expanding the plurality of wedges along the extension direction includes:
moving the inner engagement surface of the first interlocking feature (188) of the first wedge (116) to engage with the inner engagement surface of the first interlocking feature (188) of the second wedge (108).

11. A method for securing an electronic module to a body, the method comprising:
providing a rail (104) that defines an extension axis (128) extending through a center of the rail (104);
arranging a plurality of wedges along the rail (104), the plurality of wedges being engaged with the rail (104) to be adjustable axially and radially relative to the extension axis (128), to move between a first configuration and a second configuration, each of a first wedge (116) and a second wedge (108) of the plurality of wedges integrally including a wedge body (158) that defines a center axis (176) substantially parallel to the extension axis (128), a first interlocking feature (188) extending from a first body end of the wedge body (158), and a second interlocking feature (188) extending from the first body end and offset from the first interlocking feature (188) along the center axis (176);
adjusting the plurality of wedges from the first configuration to the second configuration using an adjustment device (236) by compressing the plurality of wedges in a compression direction to urge a first ramped end portion (140) of the first wedge (116) against a second ramped end portion (132) of the second wedge (108) so that the first wedge (116) moves radially away from the rail (104) in an expansion direction; and
adjusting the plurality of wedges from the second configuration to the first configuration using the adjustment device (236) by expanding the plurality of wedges along an extension direction, opposite the compression direction, so that the first and second interlocking features (188) of the first wedge (116) engage, respectively, the second and first interlocking features (188) of the second wedge (108), to urge the first wedge (116) one or more of: in the extension direction, or opposite the expansion direction.

12. The method of claim 11, wherein for each of the first and second wedges (116, 108):
a distal end of the first interlocking feature (188) that is disposed axially opposite the wedge body (158) is offset along the center axis (176) from a distal end of the second interlocking feature (188) that is disposed axially opposite the wedge body (158) along the center axis (176);
and, optionally or preferably, wherein the first interlocking feature (188) and the second interlocking feature (188) are asymmetrical relative to one another about a center plane extending radially from the center axis (176) along the expansion direction.

13. The method of claim 11, wherein each of the first ramped end portion (140) and the second ramped end portion (132) includes, for the corresponding first or second wedge (108): a distal ramp at a distal end of the first interlocking feature (188), a body ramp extending along the wedge body (158), and an inner engagement surface disposed between the distal ramp and the body ramp; and
wherein adjusting the wedges from the first configuration to the second configuration includes the distal ramp of each of the first and second wedges (116, 108) being urged against the body ramp of the other of the first and second wedges (116, 108);
and, optionally or preferably, wherein adjusting the wedges from the second configuration to the first configuration by expanding the plurality of wedges along the extension direction includes:
moving the inner engagement surface of the first interlocking feature (188) of the first wedge (116) to engage with the inner engagement surface of the first interlocking feature (188) of the second wedge (108).

14. The method of claim 11, wherein the first interlocking feature (188) includes a first hook (192) that includes:
a shank that extends from the first end of the wedge body (158) to a projection, the projection extending from the shank toward the center axis (176),
the projection including a distal ramp that is disposed axially opposite the wedge body (158) along the center axis (176),
the first projection including an inner engagement surface, disposed between the distal ramp and the wedge body (158),
wherein the inner engagement surface and the distal ramp are non-parallel;
and, optionally or preferably, wherein the wedge body (158) includes a first body ramp disposed at the first end of the wedge body (158), the first body ramp being non-parallel relative to the inner engagement surface.

15. The method of claim 11, wherein the first interlocking feature (188) includes a first hook (192), the first hook (192) including:
a first shank that extends from the first end of the wedge body (158) to a first projection, the first projection extending from the first shank toward the center axis (176), and
the first projection including an engagement surface, the engagement surface being oriented substantially perpendicular to the center axis (176).
